(19) Europäisches Patentamt
European Patent Office
Office européen des brevets

(11) EP 4 159 800 A1

(12) # EUROPEAN PATENT APPLICATION
published in accordance with Art. 153(4) EPC

(43) Date of publication:
**05.04.2023 Bulletin 2023/14**

(21) Application number: **21817929.9**

(22) Date of filing: **31.05.2021**

(51) International Patent Classification (IPC):
***C08K 5/00*** *(2006.01)* ***C08K 11/00*** *(2006.01)*
***C08L 65/00*** *(2006.01)* ***H01L 51/46*** *(2006.01)*
***H01L 51/42*** *(2006.01)*

(52) Cooperative Patent Classification (CPC):
**C08K 5/00; C08K 11/00; C08L 65/00; H10K 30/00; H10K 85/00;** Y02E 10/549

(86) International application number:
**PCT/JP2021/020603**

(87) International publication number:
**WO 2021/246351 (09.12.2021 Gazette 2021/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.06.2020 JP 2020095836**

(71) Applicant: **Nissan Chemical Corporation**
**Tokyo 103-6119 (JP)**

(72) Inventors:
- **SUGAWARA Shun**
  **Funabashi-shi, Chiba 274-0052 (JP)**
- **MAEDA Shinichi**
  **Funabashi-shi, Chiba 274-0052 (JP)**

(74) Representative: **Mewburn Ellis LLP**
**Aurora Building**
**Counterslip**
**Bristol BS1 6BX (GB)**

(54) **COMPOSITION FOR HOLE COLLECTING LAYER OF ORGANIC PHOTOELECTRIC CONVERSION ELEMENT**

(57) Provided is a composition for a hole collecting layer of an organic photoelectric conversion element, the composition containing a solvent and an electron transporting substance comprising a polythiophene derivative that includes a repeating unit represented by formula (1) or formula (1').

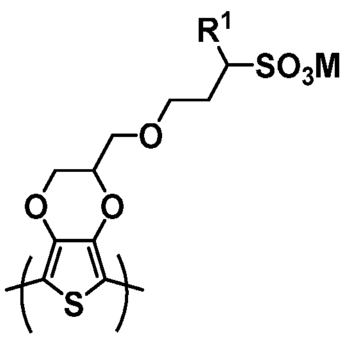

**(1)**

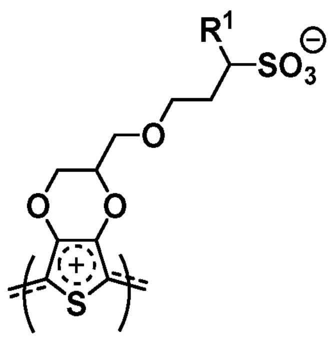

**(1')**

(In formula (1) and formula (1'), $R^1$ denotes an alkyl group having 1-6 carbon atoms or a fluorine atom. In formula (1), M denotes a hydrogen atom, an alkali metal selected from the group consisting of Li, Na and K, $NH(R^2)_3$ or $HNC_5H_5$. $R^2$ groups are each independently a hydrogen atom or an optionally substituted alkyl group having 1-6 carbon atoms.)

EP 4 159 800 A1

## Description

### TECHNICAL FIELD

The present invention relates to a composition for a hole collection layer of an organic photoelectric conversion element.

### BACKGROUND ART

An electronic element, particularly an organic photoelectric conversion element is a device which converts light energy into electric energy by use of an organic semiconductor, and examples thereof include organic solar cells.

The organic solar cell is a solar cell element in which an organic substance is used for an active layer and a charge-transporting substance, and a dye-sensitized solar cell developed by M. Gratzel and an organic thin-film solar cell developed by CW Tang are well known (Non-Patent Documents 1 and 2).

Both the cells are lightweight and thin, and have features different from those of currently prevailing inorganic solar cells in that the cells can be made flexible and produced through a roll-to-roll process. Therefore, formation of a new market is expected.

Among them, the organic thin-film solar cell has been attracted a lot of attention because the cell has the features of being free from electrolytes and free from metal compounds, and has been recently reported to have a photoelectric conversion efficiency (hereinafter, abbreviated as PCE) of 10.6% by groups in UCLA etc. (Non-Patent Document 3).

On the other hand, in contrast to a photoelectric conversion element in which a conventional silicon-based material is used, the organic thin-film solar cell has features such that high photoelectric conversion efficiency is exhibited even at a low illuminance, it is possible to thin the element and make pixels finer, and it is possible to also have the properties of a color filter, and therefore the organic thin-film solar cell has received attention not only as a solar cell but also as an optical sensor such as an image sensor (Patent Documents 1 and 2 and Non-Patent Document 4). Hereinafter, the "organic photoelectric conversion element (hereinafter, sometimes referred to as OPV)" is a collective term which refers not only to organic solar cells (dye-sensitized solar cell and organic thin-film solar cell) but also optical sensors and the like.

The organic photoelectric conversion element includes an active layer (photoelectric conversion layer), a charge (hole or electron) collection layer, electrodes (anode, cathode) and the like.

Among them, the active layer and the charge collection layer are generally formed by a vacuum evaporation method, and the vacuum deposition method has problems regarding complexity associated with mass productions, increased costs of apparatuses, material utilization efficiency and the like.

From these reasons, a water-dispersible polymer organic conductive material such as PEDOT/PSS may be used as a coating material for a hole collection layer, but the PEDOT/PSS aqueous dispersion has insufficient heat resistance in addition to the problem that defects are easily generated in a coating film and a coating apparatus is easily clogged and corroded because of the property of allowing solid contents to easily aggregate. Thus, there remain various problems in mass production.

### PRIOR ART DOCUMENTS

### PATENT DOCUMENTS

Patent Document 1: JP-A 2003-234460
Patent Document 2: JP-A 2008-258474
Patent Document 3: WO 2019/176662


### NON-PATENT DOCUMENTS

Non-Patent Document 1: Nature, vol.353, 737-740 (1991)
Non-Patent Document 2: Appl. Phys. Lett., Vol.48, 183-185 (1986)
Non-Patent Document 3: Nature Photonics Vol.6, 153-161 (2012)
Non-Patent Document 4: Scientific Reports, Vol.5:7708, 1-7 (2015)

SUMMARY OF INVENTION

TECHNICAL PROBLEM

The present invention has been made in view of the above-described circumstances, and an object of the present invention is to provide a composition for a hole collection layer of an organic photoelectric conversion element, which gives a hole collection layer excellent in adhesion to an active layer.

SOLUTION TO PROBLEM

The present inventors have already reported a composition containing predetermined polythiophene as a charge-transporting substance, as a composition for a hole collection layer which is capable of achieving the above-described object (see Patent Document 3).

However, in this composition, metal oxide nanoparticles are essential as an adhesion-imparting component, and it is desirable to develop a composition that exhibits good adhesion to an active layer even without such an adhesion-imparting component or with a small content of the adhesion-imparting component.

In view of this point, the present inventors have extensively conducted studies on a composition that gives a thin film having excellent adhesion to an active layer even without adding an adhesion imparting component such as metal oxide nanoparticles, from the perspective of the structure of polythiophene. Resultantly, the present inventors have found that among the compounds covered by the polythiophene of Patent Document 3, a polythiophene derivative having a structure in which a cyclic ethylenedioxy group is fused with a thiophene ring, and further having a predetermined side chain bonded to the cyclic ethylenedioxy group and containing a sulfonic acid or a sulfonic acid base can form a uniform solution by well dissolving in a protic polar solvent such as alcohol or water which has low corrosiveness to the active layer, and a thin film prepared from this solution exhibits high hole transportability. It has also been found that when the thin film is used as a hole collection layer of OPV, good adhesion to the active layer is exhibited even without using another adhesion-imparting component, and OPV having good PCE is obtained. In this way, the present invention has been completed.

That is, the present invention provides a composition for a hole collection layer of an organic photoelectric conversion element as described below:

1. a composition for a hole collection layer of an organic photoelectric conversion element, including: a charge-transporting substance including a polythiophene derivative containing a repeating unit represented by formula (1) or (1'); and a solvent:

[Chem. 1]

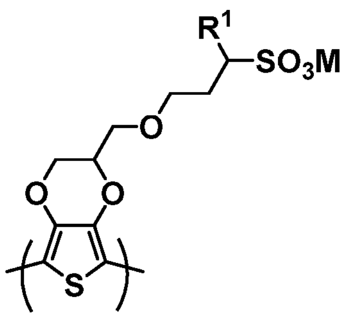

(1)

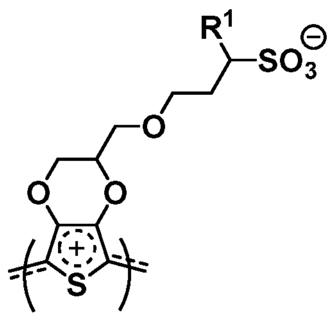

(1')

wherein in formulae (1) and (1'), $R^1$ represents an alkyl group having 1 to 6 carbon atoms, or a fluorine atom; in formula (1), M represents a hydrogen atom, an alkali metal selected from the group consisting of Li, Na and K, $NH(R^2)_3$, or $HNC_5H_5$; and $R^2$s each independently represent a hydrogen atom, or an alkyl group having 1 to 6 carbon atoms and optionally having a substituent;

2. the composition for a hole collection layer of an organic photoelectric conversion element according to 1, further including a surfactant;

3. the composition for a hole collection layer of an organic photoelectric conversion element according to 2, wherein the surfactant is a fluorine-based surfactant;

4. the composition for a hole collection layer of an organic photoelectric conversion element according to any one of 1 to 3, further including an electron-accepting dopant substance different from the polythiophene derivative containing a repeating unit represented by the formula (1) or (1');

5. the composition for a hole collection layer of an organic photoelectric conversion element according to 4, wherein the electron-accepting dopant substance different from the polythiophene derivative containing a repeating unit represented by the formula (1) or (1') is an arylsulfonic acid compound;

6. a hole collection layer obtained from the composition for a hole collection layer of an organic photoelectric conversion element in any one of 1 to 5; and

7. an organic photoelectric conversion element including the hole collection layer of 6.

## ADVANTAGEOUS EFFECTS OF INVENTION

Since the composition for a hole collection layer of an organic photoelectric conversion element according to the present invention contains a predetermined polythiophene derivative, the hole collection layer obtained from the composition is excellent in adhesion to an active layer, and as a result, an organic thin-film solar cell excellent in PCE can be obtained.

## DESCRIPTION OF EMBODIMENTS

The present invention is described in more detail below.

A composition for a hole collection layer according to the present invention includes a charge-transporting substance including a polythiophene derivative containing a repeating unit represented by formula (1) or (1'); and a solvent:

[Chem. 2]

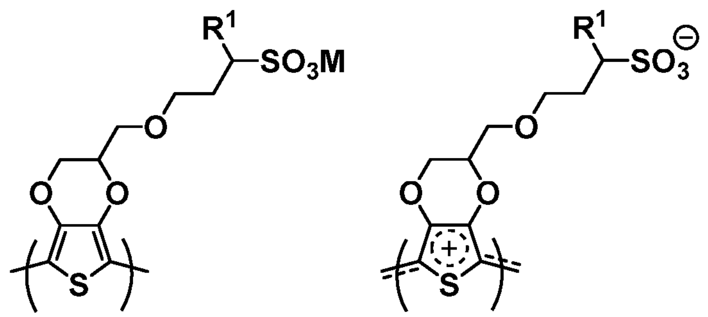

(1) (1')

In formula (1) and (1'), $R^1$ represents an alkyl group having 1 to 6 carbon atoms, or a fluorine atom. In formula (1), M represents a hydrogen atom, an alkali metal selected from the group consisting of Li, Na and K, $NH(R^2)_3$, or $HNC_5H_5$; and $R^2$s each independently represent a hydrogen atom, or an alkyl group having 1 to 6 carbon atoms and optionally having a substituent.

The alkyl group of 1 to 6 carbon atoms may be linear, branched or cyclic, and specific examples thereof include methyl, ethyl, n-propyl, i-propyl, n-butyl, isobutyl, sec-butyl, tert-butyl, n-pentyl, isopentyl, neopentyl, tert-pentyl, cyclopentyl, n-hexyl, 2-ethylbutyl, cyclohexyl, and n-octyl groups.

Among them, $R^1$ is preferably a linear or branched alkyl group having 1 to 3 carbon atoms, more preferably a methyl group or an ethyl group, still more preferably a methyl group.

As the alkyl group having 1 to 6 carbon atoms for $R^2$, the same groups as those for $R^1$ above can be exemplified.

When $R^2$ is an alkyl group having a substituent, examples of the substituent include an alkyl group having 1 to 6 carbon atoms, an alkoxy group having 1 to 6 carbon atoms, an aryl group having 6 to 20 carbon atoms, a hydroxy group, an amino group, and a carboxy group.

Examples of the alkyl group having 1 to 6 carbon atoms include the same groups as those exemplified for $R^1$ above.

Examples of the alkoxy group having 1 to 6 carbon atoms include methoxy, ethoxy, n-propoxy, i-propoxy, and n-butoxy. Examples of the aryl group having 6 to 20 carbon atoms include phenyl, tolyl, 1-naphthyl, 2-naphthyl, 1-anthryl, 2-anthryl, 9-anthryl, 1-phenanthryl, 2-phenanthryl, 3-phenanthryl, 4-phenanthryl, and 9-phenanthryl groups.

Particularly, the substituent is preferably a hydroxy group, and examples of the alkyl group having a hydroxy group include a 2-hydroxyethyl group, a 3-hydroxypropyl group, a 2-hydroxypropyl group, and a 2,3-dihydroxypropyl group.

Among them, $R^2$ is preferably a hydrogen atom or a linear or branched alkyl group having 1 to 3 carbon atoms, more preferably a hydrogen atom or a methyl group.

Examples of the preferred form of the polythiophene derivative containing a repeating unit represented by the above formula (1) include polythiophene containing a repeating unit represented by the following formula (1-1).

[Chem. 3]

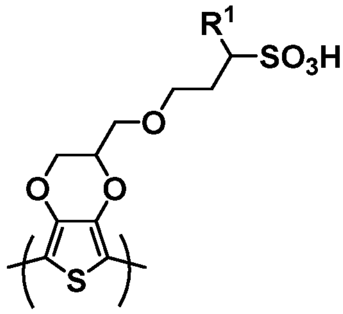

(1-1)

wherein $R^1$ is the same as described above.

Specific preferred examples of the polythiophene derivative include polythiophene containing at least one of repeating units represented by the following formulae (1-1-A) to (1-1-B) and (1-A) to (1'-B).

[Chem. 4]

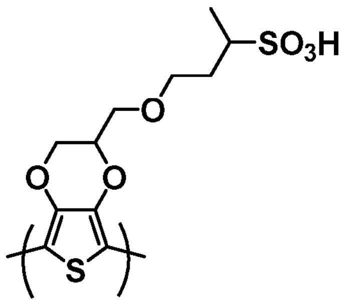

(1-1-A)

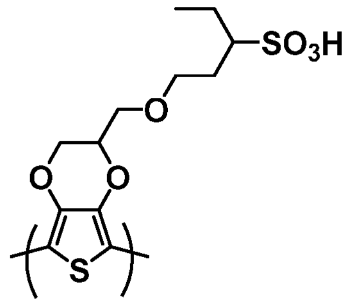

(1-1-B)

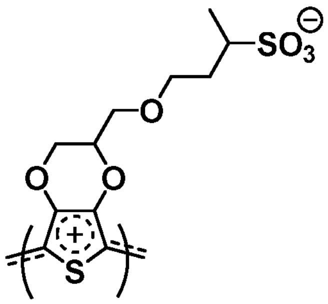

(1'-A)

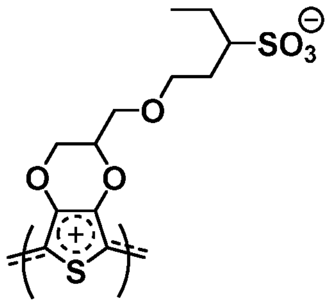

(1'-B)

Further, the polythiophene derivative may be a homopolymer or a copolymer (including statistical, random, gradient and block copolymers). Examples of the polymer containing the monomer A and the monomer B include A-B diblock copolymers, A-B-A triblock copolymers and $(AB)_m$-multi-block copolymers. The polythiophene derivative may contain repeating units derived from other types of monomers (e.g. thienothiophene, selenophene, pyrrole, furan, tellurophene, aniline, arylamine, and arylene such as phenylene, phenylenevinylene or fluorene).

In the present invention, the content of the repeating unit represented by formula (1) or (1') in the polythiophene derivative is preferably more than 50 mol%, more preferably 80 mol% or more, still more preferably 90 mol% or more, still more preferably 95 mol% or more, and most preferably 100 mol% in all repeating units contained in the polythiophene derivative.

In the present invention, depending on the purity of a starting monomer used for polymerization, the polymer formed may contain repeating units derived from impurities. In the present invention, the term "homopolymer" described above means a polymer containing repeating units derived from one type of monomer, but the homopolymer may contain repeating units derived from impurities. In the present invention, the polythiophene derivative is preferably a homopolymer in which all repeating units are basically repeating units represented by the above formula (1), more preferably a homopolymer in which the repeating units are those represented by the above formula (1-1), still more preferably a homopolymer in which the repeating units are those represented by the above formula (1-1-A) to (1-1-B).

The polythiophene derivative for use in the present invention which contains a repeating unit represented by the above formula (1) or (1') may be one produced by a heretofore known method, or a commercially available product.

Examples of the known method include a method disclosed in JP-A 2014-65898, where a thiophene monomer as shown below is provided as a raw material, and polymerized in the presence of an oxidizing agent in water or an alcohol solvent to produce the polythiophene derivative.

On the other hand, examples of the commercially available product include SELFTRON S and SELFTRON H of SELFTRON (registered trademark) series (both manufactured by Tosoh Corporation).

Examples of the thiophene monomers that can be used include sodium 3-[(2,3-dihydrothieno[3,4-b]-[1,4]dioxin-2-yl)methoxy]-1-methyl-1-propanesulfonate, sodium 3-[(2,3-dihydrothieno[3,4-b]-[1,4]dioxin-2-yl)methoxy]-1-ethyl-1-propanesulfonate, sodium 3-[(2,3-dihydrothieno[3,4-b]-[1,4]dioxin-2-yl)methoxy]-1-propyl-1-propanesulfonate, sodium 3-[(2,3-dihydrothieno[3,4-b]-[1,4]dioxin-2-yl)methoxy]-1-butyl-1-propanesulfonate, sodium 3-[(2,3-dihydrothieno[3,4-b]-[1,4]dioxin-2-yl)methoxy]-1-pentyl-1-propanesulfonate, sodium 3-[(2,3-dihydrothieno[3,4-b]-[1,4]dioxin-2-yl)methoxy]-1-hexyl-1-propanesulfonate, sodium 3-[(2,3-dihydrothieno[3,4-b]-[1,4]dioxin-2-yl)methoxy]-1-isopropyl-1-propanesulfonate, sodium 3-[(2,3-dihydrothieno[3,4-b]-[1,4]dioxin-2-yl)methoxy]-1-isobutyl-1-propanesulfonate, sodium 3-[(2,3-dihydrothieno[3,4-b]-[1,4]dioxin-2-yl)methoxy]-1-isopentyl-1-propanesulfonate, sodium 3-[(2,3-dihydrothieno[3,4-b]-[1,4]dioxin-2-yl)methoxy]-1-fluoro-1-propanesulfonate, potassium 3-[(2,3-dihydrothieno[3,4-b]-[1,4]dioxin-2-yl)methoxy]-1-methyl-1-propanesulfonate, 3-[(2,3-dihydrothieno[3,4-b]-[1,4]dioxin-2-yl)methoxy]-1-methyl-1-propanesulfonic acid, ammonium 3-[(2,3-dihydrothieno[3,4-b]-[1,4]dioxin-2-yl)methoxy]-1-methyl-1-propanesulfonate, triethylammonium 3-[(2,3-dihydrothieno[3,4-b]-[1,4]dioxin-2-yl)methoxy]-1-methyl-1-propane sulfonate.

The weight average molecular weight of the polythiophene derivative containing a repeating unit represented by formula (1) or (1') is not particularly limited, and is typically preferably about 1,000 to 1,000,000 in terms of polystyrenesulfonic acid, and more preferably about 1,000 to 200,000 when the polythiophene derivative is used as a water-soluble conductive polymer. When the weight average molecular weight is equal to or more than the lower limit, good electrical conductivity is obtained, and when the weight average molecular weight is equal to or less than the upper limit, solubility in a solvent is improved. The weight average molecular weight is a value measured by gel permeation chromatography and calculated in terms of polystyrenesulfonic acid.

In the composition of the present invention, the polythiophene derivative containing repeating units represented by the formula (1) or (1') may be used singly, or used in the form of a combination of two or more compounds.

In the organic thin film solar cell, the ionization potential of the hole collection layer is preferably a value close to the ionization potential of a p-type semiconductor material in an active layer. The absolute value of the difference between the ionization potentials is preferably 0 to 1 eV, more preferably 0 to 0.5 eV, still more preferably 0 to 0.2 eV.

Therefore, the composition for hole collection layer according to the present invention may contain an electron-accepting dopant substance for the purpose of adjusting the ionization potential of a hole collection layer obtained by use of the composition.

The electron-accepting dopant substance is not particularly limited as long as it is soluble in at least one solvent used.

Specific examples of the electron-accepting dopant substance include inorganic strong acids such as hydrogen chloride, sulfuric acid, nitric acid and phosphoric acid; Lewis acids such as aluminum chloride (III) ($AlCl_3$), titanium tetrachloride (IV) ($TiCl_4$), boron tribromide ($BBr_3$), boron trifluoride ether complex ($BF_3 \cdot OEt_2$), iron chloride (III) ($FeCl_3$), copper chloride (II) ($CuCl_2$), antimony pentachloride (V) ($SbCl_5$), arsenic pentafluoride (V) (AsFs), phosphorus pentafluoride ($PF_5$) and tris(4-bromophenyl)aluminum hexachloroantimonate (TBPAH); organic strong acids such as benzenesulfonic acid, tosylic acid, hydroxybenzenesulfonic acid, 5-sulfosalicylic acid, dodecylbenzenesulfonic acid, polystyrene sulfonic acid, the 1,4-benzodioxanedisulfonic acid compound described in WO 2005/000832, the naphthalene sulfonic acid compound described in WO 2006/025342, the arylsulfonic acid compounds such as dinonylnaphthalene sulfonic acid and 1,3,6-naphthalenetrisulfonic acid described in JP-A-2005-108828, and camphorsulfonic acid; sulfonates such as sodium polystyrenesulfonate; organic oxidants such as 7,7,8,8-tetracyanoquinodimethane (TCNQ), 2,3-dichloro-5,6-dicyano-1,4-benzoquinone (DDQ) and iodine; and inorganic oxidants such as the heteropolyacid compounds such as phosphomolybdic acid, phosphotungstic acid and phosphotungstomolybdic acid described in WO 2010/058777. These compounds may be used singly, or in combination of two or more thereof.

In the present invention, among the various electron-accepting dopant substances, particularly Broensted acid that donates $H^+$ is preferable, arylsulfonic acid compounds are more preferable, and polystyrenesulfonic acid and arylsulfonic acid compounds represented by the following formula (2) are particularly preferable. Acid compounds are preferable.

[Chem. 5]

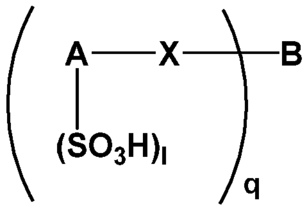

(2)

wherein X represents O, A represents a naphthalene ring or anthracene ring, B represents a divalent to tetravalent perfluorobiphenyl group, l represents the number of sulfonic acid groups bonded to A, and is an integer satisfying $1 \leq l \leq 4$, and q represents the number of bonds between B and X, and is an integer of 2 to 4.

Examples of the arylsulfonic acid compound that can be suitably used in the present invention include the

following compounds (formula (2-1)).

[Chem. 6]

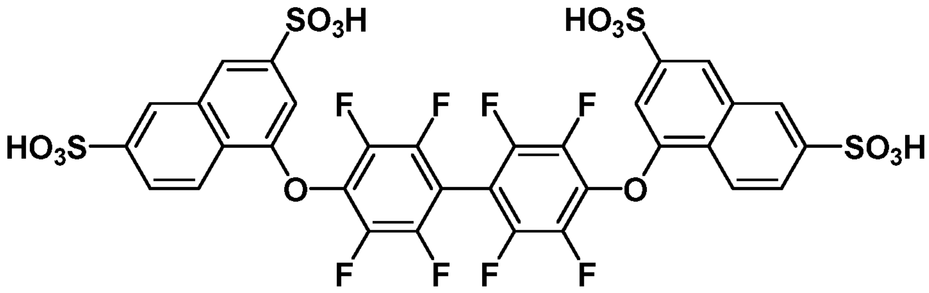

(2-1)

Further, the composition of the present invention may contain a surfactant from the viewpoint of film formability. The surfactant is not particularly limited, and a fluorine-based surfactant, a silicone-based surfactant or the like can be used. In the present invention it is preferable to use a fluorine-based surfactant.

The fluorine-based surfactant for use in the present invention can be obtained as a commercialized product.

Examples of the commercialized product include, but are not limited to, Capstone (registered trademark) FS-10, FS-22, FS-30, FS-31, FS-34, FS-35, FS-50, FS-51, FS-60, FS-61, FS-63, FS-64, FS-65, FS-66, FS-81, FS-83 and FS-3100 manufactured by DuPont, Inc.; NOIGEN FN-1287 manufactured by DKS Co., Ltd; and MEGAFACE F-444, F-477 and F-559 manufactured by DIC Corporation.

In particular, Capstone FS-30, 31, 34, 35 and 3100, NOIGEN FN-1287 and MEGAFACE F-559, which are nonionic surfactants, are preferred.

The fluorine-based surfactant is not particularly limited as long as it contains a fluorine atom, and may be cationic, anionic or nonionic, and a fluorine-based nonionic surfactant is suitable. In particular, at least one fluorine-based nonionic surfactant selected from compounds of the following formulae (A1) and (B1) is preferable.

[Chem. 7]

$RCOO(CH_2CH_2O)_nH$ (A1)

$R(CH_2CH_2O)_nH$ (B1)

In the above formulae, R represents a monovalent organic group containing a fluorine atom, and n represents an integer of 1 to 20.

Specific examples of the organic group include alkyl groups having 1 to 40 carbon atoms, aryl groups having 6 to 20 carbon atoms, aralkyl groups having 7 to 20 carbon atoms, and heteroaryl groups having 2 to 20 carbon atoms.

The alkyl group having 1 to 40 carbon atoms may be linear, branched or cyclic, and specific examples thereof include methyl, ethyl, n-propyl, isopropyl, n-butyl, isobutyl, s-butyl, t-butyl, n-pentyl, n-hexyl, n-heptyl, n-octyl, n-nonyl, n-decyl, n-undecyl, n-dodecyl, n-tridecyl, n-tetradecyl, n-pentadecyl, n-hexadecyl, n-heptadecyl, n-octadecyl, n-nonadecyl, n-eicosanyl, behenyl, triacontyl and tetracontyl groups. An alkyl group having 1 to 18 carbon atoms is preferable, and an alkyl group having 1 to 8 carbon atoms is more preferable.

Specific examples of the aralkyl group having 7 to 20 carbon atoms include benzyl, p-methylphenylmethyl, m-methylphenylmethyl, o-ethylphenylmethyl, m-ethylphenylmethyl, p-ethylphenylmethyl, 2-propylphenylmethyl, 4-isopropylphenylmethyl, 4-isobutylphenylmethyl and $\alpha$-naphthylmethyl groups.

Specific examples of the heteroaryl group include 2-thienyl, 3-thienyl, 2-furanyl, 3-furanyl, 2-oxazolyl, 4-oxazolyl, 5-oxazolyl, 3-isoxazolyl, 4-isoxazolyl, 5-isoxazolyl, 2-thiazolyl, 4-thiazolyl, 5-thiazolyl, 3-isothiazolyl, 4-isothiazolyl, 5-isothiazolyl, 2-imidazolyl, 4-imidazolyl, 2-pyridyl, 3-pyridyl, 4-pyridyl, 2-pyrazyl, 3-pyrazyl, 5-pyrazyl, 6-pyrazyl, 2-pyrimidyl, 4-pyrimidyl, 5-pyrimidyl, 6-pyrimidyl, 3-pyridazyl, 4-pyridazyl, 5-pyridazyl, 6-pyridazyl, 1,2,3-triazin-4-yl, 1,2,3-triazin-5-yl, 1,2,4-triazin-3-yl, 1,2,4-triazin-5-yl, 1,2,4-triazin-6-yl and 1,3,5-triazin-2-yl groups.

In addition, specific examples of the aryl group include the same as those described above.

n is not particularly limited as long as it is an integer of 1 to 20, and an integer of 1 to 10 is more preferable.

Of these, at least one fluorine-based nonionic surfactant selected from a perfluoroalkyl polyoxyethylene ester represented by the following formula (A2) and a perfluoroalkyl polyoxyethylene ether or fluorotelomer alcohol represented by the formula (B2), each of which has a perfluoroalkyl group $R_f$ having 1 to 40 carbon atoms, is preferable.

[Chem. 8]

$$R_fCOO(CH_2CH_2O)_nH \quad (A2)$$

$$R_f(CH_2CH_2O)_nH \quad (B2)$$

wherein n represents the same meaning as described above.

Specific examples of the perfluoroalkyl group having 1 to 40 carbon atoms include groups in which all hydrogen atoms of the above-described alkyl group having 1 to 40 carbon atoms are replaced by fluorine atoms.

In the composition of the present invention, the content of the surfactant is not particularly limited, and is preferably about 0.005 to 0.08 wt%, more preferably 0.005 to 0.05 wt%, still more preferably 0.005 to 0.04 wt%, even more preferably 0.0075 to 0.03 wt%, most preferably 0.01 to 0.02 wt%, per total amount of the composition, from the viewpoint of a balance between improvement of film formability on the active layer and reduction of adhesion to the active layer and photoelectric conversion efficiency by addition.

Since the composition of the present invention contains the polythiophene derivative represented by the formula (1) described above, the composition gives a thin film that exhibits sufficient adhesion to the active layer even without containing metal oxide nanoparticles, and may contain one or more types of metal oxide nanoparticles for further improving the adhesion to the active layer.

The term "nanoparticles" means fine particles in which primary particles have a mean particle size in the order of nanometers (typically 500 nm or less). The term "metal oxide nanoparticles" means a metal oxide formed into nanoparticles.

The primary particle size of metal oxide nanoparticles for use in the present invention is not particularly limited as long as it is a nanosize, and from the viewpoint of further enhancing adhesion with the active layer, the primary particle size is preferably 2 to 150 nm, more preferably 3 to 100 nm, still more preferably 5 to 50 nm. The particle size is a value measured by a BET method using a nitrogen adsorption isotherm.

The metal forming the metal oxide nanoparticles in the present invention includes semimetals in addition to metals in a normal sense.

The metal in a normal sense is not particularly limited, and it is preferable to use one or more selected from the group consisting of tin (Sn), titanium (Ti), aluminum (Al), zirconium (Zr), zinc (Zn), niobium (Nb), tantalum (Ta) and W (tungsten).

On the other hand, the semimetal means an element having chemical and/or physical properties intermediate between a metal and a non-metal. Universal definition of semimetals has not been established, and in the present invention, a total of six elements: boron (B), silicon (Si), germanium (Ge), arsenic (As), antimony (Sb), and tellurium (Te) are semimetals. These semimetals may be used singly, or in combination of two or more thereof, or used in combination with metals in a normal sense.

Preferably, the metal oxide nanoparticles for use in the present invention contain an oxide of one or more metals selected from boron (B), silicon (Si), germanium (Ge), arsenic (As), antimony (Sb), tellurium (Te), tin (Sn), titanium (Ti), aluminum (Al), zirconium (Zr), zinc (Zn), niobium (Nb), tantalum (Ta) and W (tungsten). When the metal is a combination of two or more metals, the metal oxide may be a mixture of oxides of single metals or a complex oxide containing a plurality of metals.

Specific examples of the metal oxide include $B_2O_3$, $B_2O$, $SiO_2$, SiO, $GeO_2$, GeO, $As_2O_4$, $As_2O_3$, $As_2O_5$, $Sb_2O_3$, $Sb_2O_5$, $TeO_2$, $SnO_2$, $ZrO_2$, $Al_2O_3$ and ZnO, and $B_2O_3$, $B_2O$, $SiO_2$, SiO, $GeO_2$, GeO, $As_2O_4$, $As_2O_3$, $As_2O_5$, $SnO_2$, SnO, $Sb_2O_3$, $TeO_2$ and mixtures thereof are preferable, with $SiO_2$ being more preferable.

The metal oxide nanoparticles may contain one or more organic capping groups. The organic capping group may be reactive or non-reactive. Examples of the reactive organic capping group include organic capping groups that can be crosslinked by an ultraviolet ray or a radical initiator.

When the composition of the present invention contains metal oxide nanoparticles, the content thereof is not particularly limited, and is preferably less than 50 parts by weight, more preferably 30 parts by weight or less, still more preferably 10 parts by weight or less per 100 parts by weight of the charge-transporting substance from the viewpoint of sufficiently exhibiting the advantages of the present invention.

When the charge-transporting substance is used as a solution or a dispersion, the addition amount of the metal oxide nanoparticles is based on the amount of solid contents in the charge-transporting substance.

In particular, in the present invention, it is preferable to use silica sol in which $SiO_2$ nanoparticles are dispersed in a dispersion medium as the metal oxide nanoparticles.

The silica sol is not particularly limited, and may be appropriately selected from known silica sols.

Commercialized silica sol is normally in the form of a dispersion. Examples of the commercialized silica sol include silica sols with $SiO_2$ nanoparticles dispersed in various solvents, for example water, methanol, methyl ethyl ketone, methyl isobutyl ketone, N,N-dimethylacetamide, ethylene glycol, isopropanol, methanol, ethylene glycol monopropyl ether, cyclohexanone, ethyl acetate, toluene, propylene glycol monomethyl ether and acetate.

In particular, in the present invention, silica sol having an alcohol solvent or water as dispersion medium is preferable, and silica sol having an alcohol solvent as a dispersion medium is more preferable. The alcohol solvent is preferably a water-soluble alcohol, more preferably methanol, 2-propanol or ethylene glycol.

Specific examples of the commercialized silica sol include, but are not limited to, SNOWTEX (registered trademark) ST-O, ST-OS, ST-O-40 and ST-OL manufactured by Nissan Chemical Corporation; SILICADOL 20, 30, 40 and the like manufactured by Nippon Chemical Industrial Co., Ltd.; and Methanol Silica Sol and Organosilica Sol such as MA-ST-M, MA-ST-L, IPA-ST, IPA-ST-L, IPA-ST-ZL and EG-ST manufactured by Nissan Chemical Corporation.

The solid content concentration of the silica sol is also not particularly limited, and is preferably 5 to 60 wt%, more preferably 10 to 50 wt%, still more preferably 15 to 30 wt%.

When the composition of the present invention contains silica gel, the content thereof is preferably less than 50 parts by weight, more preferably 30 parts by weight or less, still more preferably 10 parts by weight or less per 100 parts by weight of the charge-transporting substance from the same viewpoint as described above.

The compounding amount is based on the amount of solid contents in the charge-transporting substance similarly to the above.

Further, the composition of the present invention may contain an alkoxysilane. When an alkoxysilane is contained, it is possible to improve the solvent resistance and the water resistance of the resulting thin film, improve the electron blocking property, and set the HOMO level and the LUMO level to optimal values for the active layer. The alkoxysilane may be a siloxane-based material.

As the alkoxysilane, any one or more of alkoxysilanes among tetraalkoxysilane, trialkoxysilane and dialkoxysilane can be used. In particular, tetraethoxysilane, tetramethoxysilane, phenyltriethoxysilane, phenyltrimethoxysilane, methyltriethoxysilane, methyltrimethoxysilane, 3,3,3-trifluoropropyltrimethoxysilane, dimethyldiethoxysilane and dimethyldimethoxysilane are preferable, with tetraethoxysilane being more preferable.

Examples of the siloxane-based material include polysiloxanes such as poly(tetraethoxysilane) and poly(phenylethoxysilane) which are obtained by reaction, such as hydrolysis, of the alkoxysilane.

The addition amount of the alkoxysilane is not particularly limited as long as it is an amount which allows the above-described effects to be exhibited, and the weight ratio of the alkoxysilane to the polythiophene derivative for use in the present invention is preferably 0.0001 to 100, more preferably 0.01 to 50, still more preferably 0.05 to 10.

The composition for a hole collection layer according to the present invention may further contain a matrix polymer if necessary.

Specific examples of the matrix polymer include matrix polymers containing repeating units represented by the following formula (I) and repeating units represented by the following formula (II).

[Chem. 9]

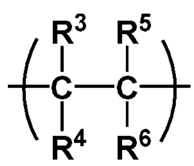

(I)

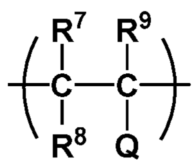

(II)

wherein $R^3$, $R^4$, $R^5$, $R^6$, $R^7$, $R^8$ and $R^9$ are each independently a hydrogen atom, a halogen atom, a fluoroalkyl group having 1 to 20 carbon atoms, or a perfluoroalkyl group having 1 to 20 carbon atoms, Q is $-[OC(R^hR^i)-C(R^jR^k)]_y-O-[CR^lR^m]_z-SO_3H$, $R^h$, $R^i$, $R^j$, $R^k$, $R^l$ and $R^m$ are each independently a hydrogen atom, a halogen atom, a fluoroalkyl group having 1 to 20 carbon atoms, or a perfluoroalkyl group having 1 to 20 carbon atoms, y is 0 to 10, and z is 1 to 5.

Specific examples of the fluoroalkyl group having 1 to 20 carbon atoms and the perfluoroalkyl group having 1 to 20 carbon atoms include the same as those described above.

Examples of the halogen atom include fluorine, chlorine, bromine and iodine atoms.

It is preferable that $R^3$, $R^4$, $R^5$ and $R^6$ are fluorine atoms or chlorine atoms, it is more preferable that $R^3$, $R^5$ and $R^6$ are fluorine atoms, and $R^4$ is a chlorine atom, and it is still more preferable that all of $R^3$, $R^4$, $R^5$ and $R^6$ are

fluorine atoms.

Preferably, all of $R^7$, $R^8$ and $R^9$ are fluorine atoms.

Preferably, $R^h$, $R^i$, $R^j$, $R^k$, $R^l$ and $R^m$ are fluorine atoms, fluoroalkyl groups having 1 to 8 carbon atoms, or perfluoroalkyl groups having 1 to 8 carbon atoms.

More preferably, $R^l$ and $R^m$ are fluorine atoms, y is preferably 0, and z is preferably 2.

Preferably, $R^3$, $R^5$ and $R^6$ are fluorine atoms, $R^4$ is a chlorine atom, and each of $R^l$ and $R^m$ is a fluorine atom; y is 0; and z is 2.

Further, in certain embodiments, it is preferable that each of $R^3$, $R^4$, $R^5$ and $R^6$ is a fluorine atom; each of $R^l$ and $R^m$ is a fluorine atom; y is 0; and z is 2.

The ratio of the number of repeating units represented by the formula (I) "s" and the number of repeating units represented by the formula (II) "t" (s : t ratio) is not particularly limited. The s : t ratio is preferably 9 : 1 to 1 : 9, more preferably 8 : 2 to 2 : 8.

The matrix polymer that can be suitably used in the present invention may be one synthesized by a known method, or a commercialized product. For example, a polymer containing repeating units represented by the formula (I) and repeating units represented by the formula (II) can be produced by copolymerizing a monomer represented by the following formula (Ia) and a monomer represented by the following formula (IIa), and subsequently performing conversion into sulfonic acid groups by hydrolysis of sulfonyl fluoride groups.

[Chem. 10]

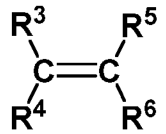

(Ia)

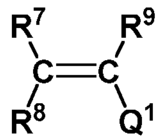

(IIa)

wherein $Q^1$ is $-[OC(R^hR^i)-C(R^jR^k)]_y-O-[CR^lR^m]_z-SO_2F$, and $R^3$, $R^4$, $R^5$, $R^6$, $R^7$, $R^8$, $R^9$, $R^h$, $R^i$, $R^j$, $R^k$, $R^l$, $R^m$, y and z have the same meanings as described above.

For example, tetrafluoroethylene (TFE) or chlorotrifluoroethylene (CTFE) can be copolymerized with one or more fluorinated monomers containing a sulfonic acid precursor group (e.g. $F_2C=CF-O-CF_2-CF_2-SO_2F$; $F_2C=CF-[O-CF_2-CR^{12}F-O]_y-CF_2-CF_2-SO_2F$ (wherein $R^{12}$ is F or $CF_3$, and y is 1 to 10); $F_2C=CF-O-CF_2-CF_2-CF_2-SO_2F$; or $F_2C=CF-OCF_2-CF_2-CF_2-CF_2-SO_2F$).

In the present invention, the equivalent amount of a matrix polymer means a weight of a matrix polymer per mol of acid groups present in the matrix polymer (g/mol). The equivalent amount of a matrix polymer is preferably about 400 to about 15,000 g/mol, more preferably about 500 to about 10,000 g/mol, still more preferably about 500 to about 8,000 g/mol, even more preferably about 500 to about 2,000 g/mol, most preferably about 600 to about 1,700 g/mol.

Such a matrix polymer can be obtained as a commercialized product.

Examples of the commercialized products include NAFION (registered trademark) manufactured by DuPont, Inc., AQUIVION (registered trademark) manufactured by Solvay Specialty Polymers, and FLEMION (registered trademark) manufactured by Asahi Glass Co., Ltd.

In the present invention, the matrix polymer is preferably polyether sulfone containing one repeating unit containing at least one sulfonic acid residue ($-SO_3H$).

The composition of the present invention may contain other additives as long as the object of the present invention can be achieved.

The types of additives can be appropriately selected from known additives according to a desired effect, and used.

As the solvent used for preparing the composition for a hole collection layer, a solvent having dissolving performance high enough to adequately dissolve the polythiophene derivative and the electron-accepting dopant substance that is used if necessary can be used. Solvents having high dissolving performance can be used singly, or in combination of two or more thereof, and the use amount thereof may be 5 to 100 wt% based on the total amount of solvents used

in the composition.

Examples of the solvent having high dissolving performance include water; alcohol-based solvents such as ethanol, 2-propanol, 1-butanol, 2-butanol, s-butanol, t-butanol, 1-methoxy-2-propanol; N-methylformamide, N,N-dimethylformamide, N,N-diethylformamide, N-methylacetamide, N,N-dimethylacetamide, N-methylpyrrolidone and 1,3-dimethyl-2-imidazolidinone.

Of these, at least one selected from water and the alcohol-based solvents is preferable, and water, ethanol and 2-propanol are more preferable.

In particular, the solvent to be used for formation of a hole collection layer of a reversely layered OPV is preferably a solvent composed only of one or more solvents selected from alcohol-based solvents and water which do not adversely affect the active layer.

It is preferable that both the charge-transporting substance and the electron-accepting dopant substance that is used if necessary are completely dissolved or uniformly dispersed in the solvent, and it is more preferable that these substances are completely dissolved in the solvent from the viewpoint of reproducibly obtaining a hole collection layer which gives an organic thin-film solar cell having high conversion efficiency.

In addition, for improving film formability and the discharging property from a coating apparatus, the composition for a hole collection layer according to the present invention may contain at least one high-viscosity organic solvent having a viscosity of 10 to 200 mPa·s, particularly 35 to 150 mPa s, at 25°C, and a boiling point of 50 to 300°C, particularly 150 to 250°C, at normal pressure.

The high-viscosity organic solvent is not particularly limited, and examples thereof includes cyclohexanol, ethylene glycol, 1,3-octylene glycol, diethylene glycol, dipropylene glycol, triethylene glycol, tripropylene glycol, 1,3-butane diol, 2,3-butanediol, 1,4-butanediol, propylene glycol and hexylene glycol.

The addition ratio of the amount of the high-viscosity organic solvent to the total amount of solvents used in the composition of the present invention is preferably within the range of not causing precipitation of solids, and the addition ratio is preferably 5 to 80 wt% as long as solids are not precipitated.

Further, for the purpose of, for example, improving wettability with a coated surface, adjusting the surface tension of the solvent, adjusting the polarity and adjusting the boiling point, another solvent capable of imparting film flatness during heat treatment can be mixed in a ratio of 1 to 90 wt%, preferably 1 to 50 wt%, to the total amount of solvents used in the composition.

Examples of the solvent include butyl cellosolve, diethylene glycol diethyl ether, diethylene glycol dimethyl ether, diethylene glycol monoethyl ether acetate, diethylene glycol monobutyl ether acetate, dipropylene glycol monomethyl ether, propylene glycol monomethyl ether, propylene glycol monomethyl ether acetate, ethyl carbitol, diacetone alcohol, $\gamma$-butyrolactone, ethyl lactate and n-hexyl acetate.

The solid content concentration of the composition of the present invention is appropriately set in consideration of the viscosity and surface tension of the composition, the thickness of the thin film to be prepared, and is typically about 0.1 to 10.0 wt%, preferably 0.5 to 5.0 wt%, more preferably 1.0 to 3.0 wt%.

In addition, the weight ratio of the charge-transporting substance and the electron-accepting dopant substance is appropriately set in consideration of charge-transportability exhibited and the type of charge-transporting substance, and the amount of the electron-accepting dopant substance is typically 0 to 10, preferably 0.1 to 3.0, more preferably 0.2 to 2.0, as a relative value against the amount of the charge-transporting substance, which is defined as 1.

The viscosity of the composition for a hole collection layer which is used in the present invention is appropriately adjusted depending on a coating method in consideration of the thickness of a thin film to be prepared and the solid content concentration, and is typically about 0.1 to 50 mPa·s at 25°C.

The charge-transporting substance, the solvent, and the fluorine-based surfactant, the metal oxide nanoparticles, the electron-accepting dopant substance and the like which are used if necessary can be mixed in any order as long as solid contents are uniformly dissolved or dispersed in the solvent in preparation of the composition for a hole collection layer according to the present invention. That is, as long as solid contents are uniformly dissolved or dispersed in the solvent, for example, any of the following methods can be employed: a method in which the polythiophene derivative is dissolved in the solvent, and the electron-accepting dopant substance is then dissolved in the resulting solution; a method in which the electron-accepting dopant substance is dissolved in the solvent, and the polythiophene derivative is then dissolved in the resulting solution; a method in which the polythiophene derivative is mixed with the electron-accepting dopant substance, and the resulting mixture is then put in the solvent and dissolved.

The matrix polymer and the alkoxysilane may be added in any order.

In addition, preparation of the composition is typically performed in an inert gas atmosphere at normal temperature and normal pressure, but may be performed in an air atmosphere (in the presence of oxygen) or performed while heat is applied as long as compounds in the composition are not decomposed, or the composition does not significantly change.

The composition described above is applied to the anode in the case of a forward layered organic thin-film solar cell, or applied to the active layer in the case of a reversely layered organic thin-film solar cell, and baked to form

the hole collection layer according to the present invention.

For the application of the composition, the most suitable method may be selected from various wet process methods such as a drop casting method, a spin coating method, a blade coating method, a dip coating method, a roll coating method, a bar coating method, a die coating method, an inkjet method, a printing method (e.g. letterpress, intaglio, lithography or screen printing) and the like in consideration of the viscosity and the surface tension of the composition, a desired thickness of the thin film, and the like.

In addition, application of the composition is typically performed in an inert gas atmosphere at normal temperature and normal pressure, but may be performed in an air atmosphere (in the presence of oxygen) or performed while heat is applied as long as compounds in the composition are not decomposed, or the composition does not significantly change.

The film thickness is not particularly limited, and in any case, the film thickness is preferably about 0.1 to 500 nm, more preferably about 1 to 100 nm. Methods for changing the film thickness include, for example, changing the solids concentration in the composition and changing the amount of solution at the time of application.

A method for producing an organic thin-film solar cell using the composition for hole collection layer according to the present invention is described below, but other methods may be applied.

(1) Forward layered organic thin-film solar cell

[Formation of anode layer]: Step of forming anode material layer on surface of transparent substrate to produce transparent electrode

Examples of the anode material include inorganic oxides such as indium tin oxide (ITO) and indium zinc oxide (IZO), metals such as gold, silver and aluminum, and high-charge-transporting organic compounds such as polythiophene derivatives and polyaniline derivatives. Of these, ITO is most preferable. As the transparent substrate, a substrate composed of glass or transparent resin can be used.

The method for forming an anode material layer (anode layer) is appropriately selected according to the properties of the anode material. Typically, a dry process such as a vacuum evaporation method or a sputtering method is selected in the case of a hardly soluble or hardly dispersible sublimation material, and in the case of a solution material or a dispersion material, the most suitable method is selected from the above-described various wet process methods in consideration of the viscosity and the surface tension of the composition, a desired thickness of the thin film, and the like.

A commercialized transparent anode substrate can also be used. In this case, it is preferable to use a substrate subjected to a smoothing treatment from the viewpoint of improving the yield of the element. When a commercialized transparent anode substrate is used, the method for producing an organic thin-film solar cell according to the present invention does not include a step of forming an anode layer.

When an inorganic oxide such as ITO is used as an anode material to form a transparent anode substrate, it is preferable to wash the substrate with a detergent, alcohol, pure water or the like before stacking an upper layer. Further, it is preferable to subject the substrate to surface treatment such as UV ozone treatment or oxygen-plasma treatment immediately before use. Surface treatment need not be carried out in cases where the anode material contains an organic substance as a principal component.

[Formation of hole collection layer]: Step of forming hole collection layer on formed anode material layer

In accordance with the above-described method, a hole collection layer is formed on the anode material layer by use of the composition of the present invention.

[Formation of active layer]: Step of forming active layer on formed hole collection layer

The active layer may be a laminate of an n-layer which is a thin film composed of an n-type semiconductor material and a p-layer which is a thin film composed of a p-type semiconductor material, or the active layer may be a non-laminated thin film composed of a mixture of these materials.

Examples of the n-type semiconductor material include fullerene, [6,6]-phenyl-$C_{61}$-butyric acid methyl ester ($PC_{61}BM$), and [6,6]-phenyl-$C_{71}$-butyric acid methyl ester ($PC_{71}BM$). On the other hand, examples of the p-type semiconductor material, polymers containing a thiophene backbone as a main chain, such as regioregular poly(3-hexylthiophene) (P3HT), PTB7 represented by the following formula (3), thienothiophene unit-containing polymers as described in JP-A-2009-158921 and WO 2010/008672, phthalocyanines such as CuPC and ZnPC, and porphyrins such as tetrabenzoporphyrin.

[Chem. 11]

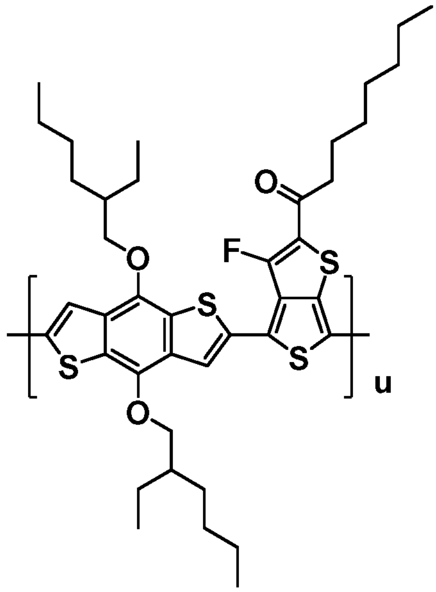

(3)

Of these, $PC_{61}BM$ and $PC_{71}BM$ are preferable as the n-type material, and polymers having a thiophene backbone as a main chain, such as PTB7, are preferable as the p-type material.

The term "thiophene backbone as a main chain" as used herein refers to a divalent aromatic ring composed only of thiophene, or a divalent fused aromatic ring containing one or more thiophenes, such as thienothiophene, benzothiophene, dibenzothiophene, benzodithiophene, naphthothiophene, naphthodithiophene, anthrathiophene and anthradithiophene. The aromatic ring may be substituted with a halogen atom, a nitro group, a cyano group, a sulfonic acid group, an alkoxy group having 1 to 20 carbon atoms, a thioalkoxy group having 1 to 20 carbon atoms, an alkyl group having 1 to 20 carbon atoms, an alkenyl group having 2 to 20 carbon atoms, an alkynyl group having 2 to 20 carbon atoms, a haloalkyl group having 1 to 20 carbon atoms, an aryl group having 6 to 20 carbon atoms, an aralkyl group having 7 to 20 carbon atoms or an acyl group having 1 to 20 carbon atoms.

Examples of the halogen atom, the alkyl group having 1 to 20 carbon atoms, the aryl group having 6 to 20 carbon atoms, and the aralkyl group having 7 to 20 carbon atoms are the same as those described above.

The alkyl group in the alkoxy group having 1 to 20 carbon atoms may be linear, branched or cyclic, and examples of the alkoxy group include methoxy, ethoxy, n-propoxy, i-propoxy, c-propoxy, n-butoxy, i-butoxy, s-butoxy, t-butoxy, n-pentoxy, n-hexoxy, n-heptyloxy, n-octyloxy, n-nonyloxy, n-decyloxy, n-undecyloxy, n-dodecyloxy, n-tridecyloxy, n-tetradecyloxy, n-pentadecyloxy, n-hexadecyloxy, n-heptadecyloxy, n-octadecyloxy, n-nonadecyloxy and n-eicosanyloxy groups.

Specific examples of the thioalkoxy group having 1 to 20 carbon atoms include groups in which the oxygen atom of the alkoxy group is replaced by a sulfur atom.

Examples of the thioalkoxy (alkylthio) group having 1 to 20 carbon atoms include methylthio, ethylthio, n-propylthio, isopropylthio, n-butylthio, isobutylthio, s-butylthio, t-butylthio, n-pentylthio, n-hexylthio, n-heptylthio, n-octylthio, n-nonylthio, n-decylthio, n-undecylthio, n-dodecylthio, n-tridecylthio, n-tetradecylthio, n-pentadecylthio, n-hexadecylthio, n-heptadecylthio, n-octadecylthio, n-nonadecylthio and n-eicosanylthio groups.

Examples of the alkenyl group having 2 to 20 carbon atoms include ethenyl, n-1-propenyl, n-2-propenyl, 1-methylethenyl, n-1-butenyl, n-2-butenyl, n-3-butenyl, 2-methyl-1-propenyl, 2-methyl-2-propenyl, 1-ethylethenyl, 1-methyl-1-propenyl, 1-methyl-2-propenyl, n-1-pentenyl, n-1-decenyl and n-1-eicosenyl groups.

Examples of the alkynyl group having 2 to 20 carbon atoms include ethynyl, n-1-propynyl, n-2-propynyl, n-1-butynyl, n-2-butynyl, n-3-butynyl, 1-methyl-2-propynyl, n-1-pentynyl, n-2-pentynyl, n-3-pentynyl, n-4-pentynyl, 1-methyl-n-butynyl, 2-methyl-n-butynyl, 3-methyl-n-butynyl, 1,1-dimethyl-n-propynyl, n-1-hexynyl, n-1-decynyl, n-1-pentadecynyl and n-1 eicosynyl groups.

Examples of the haloalkyl group having 1 to 20 carbon atoms include groups in which at least one of hydrogen atoms in the alkyl group is substituted with a halogen atom. The halogen atom may be any of chlorine, bromine, iodine and fluorine atoms. In particular, a fluoroalkyl group is preferable, and a perfluoroalkyl group is more preferable.

Specific examples thereof include fluoromethyl, difluoromethyl, trifluoromethyl, pentafluoroethyl, 2,2,2-trifluoroethyl, heptafluoropropyl, 2,2,3,3,3-pentafluoropropyl, 2,2,3,3-tetrafluoropropyl, 2,2,2-trifluoro-1-(trifluoromethyl)ethyl,

nonafluorobutyl, 4,4,4-trifluorobutyl, undecafluoropentyl, 2,2,3,3,4,4,5,5,5-nonafluoropentyl, 2,2,3,3,4,4,4,5,5-octafluoropentyl, tridecafluorohexyl, 2,2,3,3,4,5,5,6,6,6-undecafluorohexyl, 2,2,3,3,4,4,5,5,6,6-decafluorohexyl and 3,3,4,4,5,5,6,6,6-nonafluorohexyl groups.

Specific examples of the acyl group having 1 to 20 carbon atoms include formyl, acetyl, propionyl, butyryl, isobutyryl, valeryl, isovaleryl and benzoyl groups.

For the method for forming an active layer, similarly to above, any of various dry processes as described above is selected in the case where the active layer material is a hardly soluble sublimation material, and in the case of a solution material or a dispersion material, the most suitable method is selected from the above-described various wet process methods in consideration of the viscosity and the surface tension of the composition, a desired thickness of the thin film, and the like.

[Formation of electron collection layer]: Step of forming electron collection layer on formed active layer

If necessary, an electron collection layer may be formed between the active layer and the cathode layer for the purpose of enhancing the efficiency of charge transfer.

Examples of the material for forming an electron collection layer include lithium oxide ($Li_2O$), magnesium oxide (MgO), alumina ($Al_2O_3$), lithium fluoride (LiF), sodium fluoride (NaF), magnesium fluoride ($MgF_2$), strontium bromide ($SrF_2$), cesium carbonate ($Cs_2CO_3$), 8-quinolinol lithium salt (Liq), 8-quinolinol sodium salt (Naq), bathocuproin (BCP), 4,7-diphenyl-1,10-phenanthroline (BPhen), polyethyleneimine (PEI) and ethoxylated polyethyleneimine (PEIE).

For the method for forming an electron collection layer, similarly to above, any of various dry processes as described above is selected in the case where the electron collection material is a hardly soluble sublimation material, and in the case of a solution material or a dispersion material, the most suitable method is selected from the above-described various wet process methods in consideration of the viscosity and the surface tension of the composition, a desired thickness of the thin film, and the like.

[Formation of cathode layer]: Step of forming cathode layer on formed electron collection layer

Examples of the cathode material include metals such as aluminum, magnesium-silver alloys, aluminum-lithium alloys, lithium, sodium, potassium, cesium, calcium, barium, silver and gold, inorganic oxides such as indium tin oxide (ITO) and indium zinc oxide (IZO), and high-charge-transporting organic compounds such as polythiophene derivatives and polyaniline derivatives. The cathode material may be a laminate or mixture of a plurality of cathode materials.

For the method for forming a cathode layer, similarly to above, any of various dry processes as described above is selected in the case where the cathode layer material is a hardly soluble and hardly dispersible sublimation material, and in the case of a solution material or a dispersion material, the most suitable method is selected from the above-described various wet process methods in consideration of the viscosity and the surface tension of the composition, a desired thickness of the thin film, and the like.

[Formation of carrier blocking layer]

If necessary, a carrier blocking layer may be provided between any layers for the purpose of controlling the rectification of photocurrents. When the carrier blocking layer is provided, typically but not exclusively, an electron blocking layer is inserted between the active layer and the hole collection layer or the anode, and a hole blocking layer is inserted between the active layer and the electron collection layer or the cathode.

Examples of the material for forming a hole blocking layer include titanium oxide, zinc oxide, tin oxide, bathocuproine (BCP), and 4,7-diphenyl-1,10-phenanthroline (BPhen).

Examples of the material for forming an electron blocking layer include N,N'-di(1-naphthyl)-N,N'-diphenylbenzidine ($\alpha$-NPD), and triarylamine-based materials such as poly(triarylamine) (PTAA).

For the method for forming a carrier blocking layer, similarly to above, any of various dry processes as described above is selected in the case where the carrier blocking layer material is a hardly soluble and hardly dispersible sublimation material, and in the case of a solution material or a dispersion material, the most suitable method is selected from the above-described various wet process methods in consideration of the viscosity and the surface tension of the composition, a desired thickness of the thin film, and the like.

(2) Reversely layered organic thin-film solar cell

[Formation of cathode layer]: Step of forming cathode material layer on surface of transparent substrate to produce transparent cathode substrate

Examples of the cathode material include those exemplified for the forward laminated anode material above, and fluorine-doped tin oxide (FTO), and examples of the transparent substrate include those exemplified for the forward laminated anode material above.

For the method for forming a cathode material layer (cathode layer), the above-described dry process is selected in the case where the cathode layer material is a hardly soluble and hardly dispersible sublimation material, and in the case of a solution material or a dispersion material, the most suitable method is selected from the above-described various wet process methods in consideration of the viscosity and the surface tension of the composition, a desired thickness of the thin film, and the like.

In this case, a commercialized transparent cathode substrate can be suitably used, and it is preferable to use a substrate subjected to a smoothing treatment from the viewpoint of improving the yield of the element. When a commercialized transparent cathode substrate is used, the method for producing an organic thin-film solar cell according to the present invention does not include a step of forming a cathode layer.

When a transparent cathode substrate is formed with an inorganic oxide used as a cathode material, the same washing treatment or surface treatment as in the case of the forward laminated anode material may be performed.

[Formation of electron collection layer]: Step of forming electron collection layer on formed cathode

If necessary, an electron collection layer may be formed between the active layer and the cathode layer for the purpose of enhancing the efficiency of charge transfer.

Examples of the material for forming an electron collection layer include those exemplified for the forward laminated material above, zinc oxide (ZnO), titanium oxide (TiO) and tin oxide (SnO).

For the method for forming an electron collection layer, the above-described dry process is selected in the case where the cathode layer material is a hardly soluble and hardly dispersible sublimation material, and in the case of a solution material or a dispersion material, the most suitable method is selected from the above-described various wet process methods in consideration of the viscosity and the surface tension of the composition, a desired thickness of the thin film, and the like. A method may be employed in which a precursor layer of an inorganic oxide is formed on a cathode by using a wet process (particularly a spin coating method or a slit coating method), and then baked to form an inorganic oxide layer.

[Formation of active layer]: Step of forming active layer on formed electron collection layer

The active layer may be a laminate of an n-layer which is a thin film composed of an n-type semiconductor material and a p-layer which is a thin film composed of a p-type semiconductor material, or the active layer may be a non-laminated thin film composed of a mixture of these materials.

Examples of the n-type and p-type semiconductor materials include the same as those exemplified for the forward laminated semiconductor material above. $PC_{61}BM$ and $PC_{71}BM$ are preferable as the n-type material, and polymers having a thiophene backbone as a main chain, such as PTB7, are preferable as the p-type material.

The method for forming an active layer is similar to the method described for the forward laminated active layer above.

[Formation of hole collection layer]: Step of forming hole collection layer on formed active layer material layer

In accordance with the above-described method, a hole collection layer is formed on the active layer material layer by use of the composition of the present invention.

[Formation of anode layer]: Step of forming anode layer on formed hole collection layer

Examples of the anode material include the same as the above-described forward laminated anode material, and the method for forming the anode layer is the same as the method for forming the forward laminated cathode layer.

[Formation of carrier blocking layer]

If necessary, a carrier blocking layer may be provided between any layers for the purpose of controlling the

rectification of photocurrents as in the case of the forward laminated element.

The material for forming the hole blocking layer and the material for forming the electron blocking layer include the same as those described above, and the method for forming the carrier blocking layer is the same as described above.

The OPV prepared by the method exemplified above can be introduced into a glove box again, sealed in an inert gas atmosphere of nitrogen or the like for prevention of degradation of the element by air, and caused to exhibit functions as a solar cell in a sealed state, or measurement for solar cell characteristics.

Examples of the sealing method include a method in which a concave glass substrate with an UV curable resin attached to an end thereof is attached to a film-formed surface of an organic thin-film solar cell element in an inert gas atmosphere, and the resin is cured by UV irradiation; and a method in which film sealing-type sealing is performed in vacuum by a technique such as sputtering.

## EXAMPLES

Examples and Comparative Examples are given below to more concretely illustrate the invention, although the invention is not limited by these Examples. The apparatuses used are as follows.

| | |
|---|---|
| (1) Glove box: | VAC Glove Box System manufactured by YAMAHACHI & CO., LTD. |
| (2) Vapor deposition apparatus: | Vacuum Vapor Deposition Apparatus manufactured by Aoyama Engineering Co., Ltd. |
| (3) Solar simulator: | OTENTOSUN-III (AM1.5G filter, radiation intensity: 100 $mW/cm^2$) manufactured by Bunkoukeiki Co., Ltd. |
| (4) Source measure unit: | 2612A manufactured by Keithley Instruments Co., Ltd. |
| (5) Thickness measuring apparatus: | SURFCORDER ET-4000 manufactured by Kosaka Laboratory Ltd. |
| (6) Peeling test apparatus: | VERSATILE PEEL ANALYZER VPA-3 manufactured by Kyowa Interface Science Co., Ltd. |

[1] Preparation of active layer composition

[Preparation Example 1]

2.0 mL of chlorobenzene was put in a sample bottle containing 20 mg of PTB7 (manufactured by 1-Material Co.) and 30 mg of $PC_{61}BM$ (manufactured by Frontier Carbon Corporation, product name: nanom spectra E100), and the mixture was stirred on a hot plate at 80°C for 15 hours. The resulting solution was allowed to cool to room temperature, 60 μL of 1,8-diiodooctane (manufactured by Tokyo Chemical Industry Co., Ltd.) was then added, and the mixture was stirred to obtain a solution A1 (active layer composition).

[2] Production of composition for hole collection layer

[Example 1-1]

2.53 g of a polythiophene derivative (SELFTRON S manufactured by Tosoh Corporation, 2.0 wt% aqueous solution) was diluted with 2.48 g of distilled water to prepare a dark blue solution having a solid content concentration of 1.0 wt%. The obtained dark blue solution was filtered with a syringe filter with a pore size of 0.45 μm to obtain a composition B1 for a hole collection layer.

[Example 1-2]

2.53 g of a polythiophene derivative (SELFTRON S manufactured by Tosoh Corporation, 2.0 wt% aqueous solution) was diluted with 2.48 g of isopropanol, and 0.5 mg of a fluorine-based nonionic surfactant (FN-1287 manufactured by DKS Co. Ltd.) was added to prepare a dark blue solution having a solid content concentration of 1.0 wt%. The obtained dark blue solution was filtered with a syringe filter with a pore size of 0.45 μm to obtain a composition B2 for a hole collection layer.

[Comparative Example 1-1]

PEDOT/PSS (AI4083 manufactured by Heraeus K.K.) was filtered with a syringe filter with a pore size of 0.45

μm to obtain a composition C1 for a hole collection layer.

[Comparative Example 1-2]

PEDOT/PSS (Clevios HTL Solar manufactured by Heraeus K.K.) was filtered with a syringe filter with a pore size of 0.45 μm to obtain a composition C2 for a hole collection layer.

[Comparative Example 1-3]

To a dark blue solution obtained by diluting 15 g of a PEDOT:PSS (Clevios P manufactured by Heraeus K.K., 1.3 wt% aqueous dispersion) with 15 g of distilled water, a fluorine-based nonionic surfactant (FS-31 manufactured by DuPont, Inc.) was added in an amount of 0.25 wt% based on the total amount of the dark blue solution, and the mixture was filtered with a syringe filter with a pore size of 0.45 μm to obtain a composition C3 for a hole collection layer.

[3] Preparation of organic thin-film solar cell

[Example 2-1]

A 10 mm × 25 mm glass substrate in which an ITO transparent conductive layer as a positive electrode was patterned in a 25 mm × 25 mm stripe shape was subjected to UV/ozone treatment for 15 minutes, and the composition B1 for a hole collection layer, which had been prepared in Example 1-1, was then applied onto the substrate by a spin coating method. The glass substrate was heated at 100°C for 5 minutes with a hot plate to form a hole collection layer. The thickness of the hole collection layer was about 30 nm.

Thereafter, in a glove box filled with an inert gas, the solution A1 obtained in Preparation Example 1 was dropped onto the formed hole collection layer, and a film formation was performed by a spin coating method to form an active layer having a thickness of 100 nm.

Next, the substrate on which the organic semiconductor layer was formed and the mask for a negative electrode were placed in a vacuum vapor deposition apparatus, the inside of the apparatus was evacuated until the degree of vacuum was $1\times10^{-3}$ Pa or less, and a lithium 8-hydroxyquinolinolat layer as an electron collection layer was vapor-deposited to a thickness of 1 nm by a resistive heating method.

Finally, an aluminum layer as a negative electrode was vapor-deposited to a thickness of 80 nm by a resistive heating method to prepare forward layered OPV in which the area of a portion with a stripe-shaped ITO layer intersecting an aluminum layer was 10 mm × 10 mm.

[Comparative Example 2-1]

A forward layered OPV was prepared in the same manner as in Example 2-1 except that a composition C1 for a hole collection layer was used instead of the composition B1 for a hole collection layer.

[Example 3-1]

A 10 mm × 25 mm glass substrate in which an ITO transparent conductive layer as a negative electrode was patterned in a 25 mm × 25 mm stripe shape was subjected to UV/ozone treatment for 15 minutes. A zinc oxide solution (manufactured by Genes' Ink) for forming an electron collection layer was dropped onto the substrate, and film formation was performed by a spin coating method. The thickness of the electron collection layer was about 20 nm. Thereafter, in a glove box filled with an inert gas, the solution A1 obtained in Preparation Example 1 was dropped onto the formed electron collection layer, and a film formation was performed by a spin coating method to form an active layer.

Next, the composition B2 for a hole collection layer, which had been prepared in Example 1-2, was applied onto the active layer by a doctor blade method, and then dried at room temperature to form a hole collection layer. The thickness of the hole collection layer was about 300 nm.

Finally, the laminated substrate was placed in a vacuum vapor deposition apparatus, and the apparatus was evacuated until the degree of vacuum in the apparatus was $1 \times 10^{-3}$ Pa or less, and by a resistance heating method, a silver layer as a positive electrode was formed to a thickness of 200 nm to prepare reversely layered OPV in which the area of an intersection of the stripe-shaped ITO layer and the silver layer was 3 mm × 8 mm.

[Comparative Example 3-1]

A reverse layered OPV was prepared in the same manner as in Example 3-1 except that a composition C2 for

a hole collection layer was used instead of the composition B2 for a hole collection layer.

[4] Evaluation of Characteristics

For OPVs prepared in Examples 2-1 and 3-1 and Comparative Examples 2-1 and 3-1, the short-circuit current density (Jsc [mA/cm$^2$]), open circuit voltage (Voc [V]), fill factor (FF) and PCE [%] were evaluated. The results are shown in Table 1.

PCE [%] was calculated from the following expression.

$$\text{PCE [\%]} = \text{Jsc [mA/cm}^2\text{]} \times \text{Voc [V]} \times \text{FF} \div \text{incident light intensity (100 [mW/cm}^2\text{])} \times 100$$

[Table 1]

| Element structure | Example/Comparative Example | Jsc (mA/cm$^2$) | Voc (V) | FF | PCE (%) |
|---|---|---|---|---|---|
| Forward structure | Example 2-1 | 12.7 | 0.71 | 0.59 | 5.3 |
| | Comparative Example 2-1 | 12.6 | 0.76 | 0.54 | 5.1 |
| Reverse structure | Example 3-1 | 7.7 | 0.74 | 0.57 | 3.2 |
| | Comparative Example 3-1 | 7.7 | 0.74 | 0.56 | 3.2 |

As is apparent from Table 1, OPV exhibiting HTL characteristics equivalent to those of PEDOT/PSS which is practical HTL can be obtained by using the composition for a hole collection layer in each example, which contains a polythiophene derivative containing a repeating unit represented by formula (1).

[5] Preparation of adhesion test laminate

[Example 4-1]

A 25 mm × 25 mm glass substrate with an ITO transparent conductive layer was subjected to UV/ozone treatment for 15 minutes. A zinc oxide solution (manufactured by Genes' Ink) for forming an electron collection layer was dropped onto the substrate, and film formation was performed by a spin coating method. The thickness of the electron collection layer was about 30 nm. Thereafter, in a glove box filled with an inert gas, the solution A1 obtained in Preparation Example 1 was dropped onto the formed electron collection layer, and a film formation was performed by a spin coating method to form an active layer.

Next, the composition B2 for a hole collection layer, which had been prepared in Example 1-2, was applied onto the active layer by a doctor blade method, and then dried at room temperature to form a hole collection layer. The thickness of the hole collection layer was about 300 to 400 nm.

[Example 4-2]

An adhesion test laminate was prepared in the same manner as in Example 4-1 except that after the composition B2 for a hole collection layer was applied by a doctor blade method, annealing treatment was performed with a hot plate at 100°C for 5 minutes.

[Comparative Example 4-1]

An adhesion test laminate was prepared in the same manner as in Example 4-1 except that a composition C2 for a hole collection layer was used instead of the composition B2 for a hole collection layer.

[Comparative Example 4-2]

An adhesion test laminate was prepared in the same manner as in Example 4-2 except that a composition C2 for a hole collection layer was used instead of the composition B2 for a hole collection layer.

[Comparative Example 4-3]

An adhesion test laminate was prepared in the same manner as in Example 4-1 except that a composition C3 for a hole collection layer was used instead of the composition B2 for a hole collection layer.

[Comparative Example 4-4]

An adhesion test laminate was prepared in the same manner as in Example 4-2 except that a composition C3 for a hole collection layer was used instead of the composition B2 for a hole collection layer.

By using the composition for a hole collection layer according to the present invention in which the polymer represented by formula (1) was used, film formability better than that obtained using other self-doped polymers was obtained.

[4] Adhesion test

In accordance with the following method, a peeling test was conducted on the laminates prepared in Examples 4-1 and 4-2 and Comparative Examples 4-1 to 4-4.

To the film to be evaluated, a cellophane tape having a width of 18 mm and an adhesion strength of 4 N/cm was bonded over the entire surface of the substrate on the film surface side, and peeling was performed at a tension speed of 2 mm/min in a direction of about 90 ° to evaluate the adhesion strength. The results are shown in Table 2. The adhesion strength is represented by the maximum value in the measurement range.

[Table 2]

| | Annealing | Adhesion strength (N) |
|---|---|---|
| Example 4-1 | Not done | 3.7 |
| Example 4-2 | Done | 3.6 |
| Comparative Example 4-1 | Not done | 0.0 |
| Comparative Example 4-2 | Done | 0.0 |
| Comparative Example 4-3 | Not done | 0.0 |
| Comparative Example 4-4 | Done | 0.0 |

As is apparent from Table 2, adhesion to the active layer can be significantly improved by using the composition for a hole collection layer in each example, which contains a polythiophene derivative containing a repeating unit represented by formula (1).

## Claims

1. A composition for a hole collection layer of an organic photoelectric conversion element, comprising: a charge-transporting substance including a polythiophene derivative containing a repeating unit of formula (1) or (1'); and a solvent:

[Chem. 1]

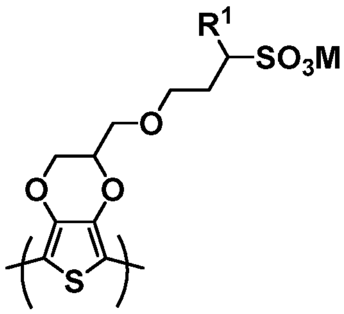

(1)

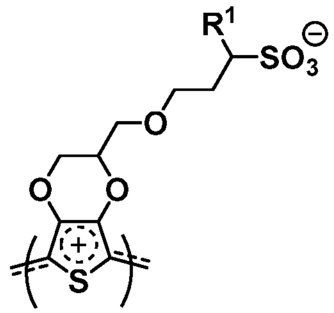

(1')

wherein in formulae (1) and (1'), $R^1$ represents an alkyl group having 1 to 6 carbon atoms, or a fluorine atom; in formula (1), M represents a hydrogen atom, an alkali metal selected from the group consisting of Li, Na and K, $NH(R^2)_3$ or $HNC_5H_5$; and $R^2$s each independently represent a hydrogen atom, or an alkyl group having 1 to 6 carbon atoms and optionally having a substituent.

2. The composition for a hole collection layer of an organic photoelectric conversion element according to claim 1, further comprising a surfactant.

3. The composition for a hole collection layer of an organic photoelectric conversion element according to claim 2, wherein the surfactant is a fluorine-based surfactant.

4. The composition for a hole collection layer of an organic photoelectric conversion element according to any one of claims 1 to 3, further comprising an electron-accepting dopant substance different from the polythiophene derivative containing repeating units represented by the above formula (1) or (1').

5. The composition for a hole collection layer of an organic photoelectric conversion element according to claim 4, wherein the electron-accepting dopant substance different from the polythiophene derivative containing a repeating unit represented by the formula (1) or (1') is an arylsulfonic acid compound.

6. A hole collection layer obtained from the composition for a hole collection layer of an organic photoelectric conversion element in any one of claims 1 to 5.

7. An organic photoelectric conversion element comprising the hole collection layer of claim 6.

**INTERNATIONAL SEARCH REPORT**

International application No. PCT/JP2021/020603

A. CLASSIFICATION OF SUBJECT MATTER

C08K 5/00(2006.01)i; C08K 11/00(2006.01)i; C08L 65/00(2006.01)i; H01L 51/46(2006.01)i; H01L 51/42(2006.01)i
FI: H01L31/04 168; H01L31/04 152E; H01L31/04 162; H01L31/08 T; C08L65/00; C08K5/00; C08K11/00

According to International Patent Classification (IPC) or to both national classification and IPC

B. FIELDS SEARCHED

Minimum documentation searched (classification system followed by classification symbols)
H01L51/42-51/48

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2019/176662 A1 (NISSAN CHEMICAL CORPORATION) 19 September 2019 (2019-09-19) paragraphs [0012]-[0101] | 1-7<br>4-5 |
| X<br>Y | JP 2020-26490 A (TOSOH CORP.) 20 February 2020 (2020-02-20) paragraphs [0011]-[0021], [0084], [0099], [0107], [0112]-[0121] | 1-3, 6-7<br>4-5 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 July 2021 (26.07.2021) | 03 August 2021 (03.08.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application no.
PCT/JP2021/020603

| Patent Documents referred in the Report | Publication Date | Patent Family | Publication Date |
|---|---|---|---|
| WO 2019/176662 A1 | 19 Sep. 2019 | US 2020/0411766 A1 paragraphs [0023]-[0143]<br>EP 3766936 A1<br>CN 111868171 A | |
| JP 2020-26490 A | 20 Feb. 2020 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003234460 A
- JP 2008258474 A
- WO 2019176662 A
- JP 2014065898 A
- WO 2005000832 A
- WO 2006025342 A
- JP 2005108828 A
- WO 2010058777 A
- JP 2009158921 A
- WO 2010008672 A

### Non-patent literature cited in the description

- *Nature,* 1991, vol. 353, 737-740
- *Appl. Phys. Lett.,* 1986, vol. 48, 183-185
- *Nature Photonics,* 2012, vol. 6, 153-161
- *Scientific Reports,* 2015, vol. 5 (7708), 1-7